# EUROPÄISCHE PATENTSCHRIFT

(11) **EP 1 546 796 B1**
(45) Veröffentlichungstag und Bekanntmachung des Hinweises auf die Patenterteilung: **22.01.2014**
(21) Anmeldenummer: 03753271.0
(22) Anmeldetag: 01.09.2003
(51) Int. Cl.: G02F 1/13357, H05B 33/08, H01L 33/60, H01L 25/075

(54) **BELEUCHTUNGSEINRICHTUNG ZUR HINTERLEUCHTUNG EINER BILDWIEDERGABEVORRICHTUNG**
ILLUMINATION DEVICE FOR BACKLIGHTING AN IMAGE REPRODUCTION DEVICE
DISPOSITIF D'ECLAIRAGE POUR RETROECLAIRER UN SYSTEME DE REPRODUCTION D'IMAGES

(30) Priorität: 30.09.2002 DE 10245892
(43) Veröffentlichungstag der Anmeldung: 29.06.2005
(73) Patentinhaber: OSRAM Opto Semiconductors GmbH, 93055 Regensburg (DE)
(72) Erfinder: NOLL, Heinrich, 64823 Gross-Umstadt (DE); MAYER, Ralf, 67295 Bolanden (DE); KROMOTIS, Patrick, 10250 Penang (MY); BOGNER, Georg, 93138 Hainsacker (DE)
(74) Vertreter: Patentanwaltskanzlei WILHELM & BECK
(86) Internationale Anmeldenummer: PCT/DE2003/002886
(87) Internationale Veröffentlichungsnummer: WO 2004/031844

(56) Entgegenhaltungen:
- EP-A- 0 864 432
- DE-U- 20 005 862
- GB-A- 2 361 581
- GB-A- 2 370 103
- US-A1- 2002 050 958
- US-A1- 2002 101 362
- US-B1- 6 194 839

## Beschreibung

Die Erfindung betrifft eine Beleuchtungseinrichtung zur Hinterleuchtung einer Lichtventile enthaltenden Bildwiedergabevorrichtung, wobei jeweils von mehreren Leuchtdioden gebildete Leuchtpunkte rasterförmig angeordnet sind.

Bildwiedergabevorrichtungen mit Lichtventilen, insbesondere Flüssigkristall-Displays, benötigen eine genügend helle und gleichmäßige Hinterleuchtung. Dies wird bei größeren Displays, wie beispielsweise Computer-Bildschirmen, mit Leuchtstoffröhren erzielt. Bei Anwendungen, die eine sehr hohe Leuchtdichte erfordern, reichen die bekannten Beleuchtungseinrichtungen jedoch nicht aus. So wird beispielsweise für sogenannte Head-up-Displays in Kraftfahrzeugen eine sehr hohe Leuchtdichte gefordert, da das Spiegelbild des Displays auch bei großer Umgebungshelligkeit noch sichtbar sein muss.

GB 2 361 581 A, auf der die Präambel von Anspruch 1 basiert, zeigt eine Anordnung mit einer Leuchtdiode, die in einer Vertiefung eines Hitze ableitenden Substrats angeordnet ist. Mehrere solcher Substrate können rasterförmig angeordnet werden, wobei eine gedruckte Schaltung sämtliche Leuchtdioden und Substrate miteinander verbindet. Diese Anordnung ist jedoch schwierig herzustellen.

Aufgabe der Erfindung ist es daher, eine Beleuchtungseinrichtung anzugeben, die auf einer gegebenen Fläche eine hohe Leuchtdichte aufweist und gleichzeitig den Ausfall einer Leuchtdiode kompensieren kann. Diese Aufgabe wird erfindungsgemäß durch eine Beleuchtungseinrichtung gemäß Anspruch 1 gelöst. Dabei sind die Leuchtdioden jeweils eines Leuchtpunktes auf der im Wesentlichen ebenen Oberfläche eines Submounts elektrisch isoliert aufgebracht sind und dass die Submounts gut wärmeleitend sind und gut wärmeleitend mit einem flachen wärmeleitenden Träger verbunden sind.

Die Erfindung nutzt in vorteilhafter Weise aus, dass eine Vielzahl von kleinen Leuchtdioden mehr Licht aussenden als eine entsprechend große, da die gesamte freie Oberfläche der Leuchtdiode strahlt. Außerdem gewährleistet die Erfindung eine gute Wärmeableitung.

Eine vorteilhafte Weiterbildung der erfindungsgemäßen Beleuchtungseinrichtung besteht darin, dass die Fläche der Submounts jeweils kleiner als die durch das Raster gegebene Fläche ist und dass auf der nicht von Submounts eingenommenen Fläche des Trägers zwischen den Submounts auf einem isolierenden Träger Leitungen zur Stromversorgung der Leuchtdioden angeordnet sind. Damit ist eine vorteilhafte wärmeleitende Verbindung zwischen den Leuchtdioden und dem Träger möglich, ohne dass die isoliert aufgebrachten Leitungen die Wärmeleitung behindern.

Diese Weiterbildung kann vorteilhaft dadurch ausgestaltet werden, dass die Leitungen in einer flexiblen Folie geführt sind, die außerhalb des Trägers als Flachleitung fortgesetzt ist. Damit ist außer der Kontaktierung der Leitungen mit den Leuchtdioden innerhalb der Beleuchtungseinrichtung keine weitere Kontaktierung erforderlich, was zur Betriebssicherheit und zur preiswerten Herstellbarkeit beiträgt.

Vorzugsweise ist bei der Erfindung vorgesehen, dass die Submounts aus Silizium bestehen. Zur weiteren Verbesserung der Wärmeableitung kann bei der Erfindung vorgesehen sein, dass der Träger aus Reinst-Aluminium oder Kupfer besteht und/oder dass der Träger mit einer Wärmesenke verbunden ist. Als Wärmesenke eignet sich beispielsweise ein großer Kühlkörper, der über eine möglichst große Oberfläche Wärme an die umgebende Luft abgibt. Es sind ferner so genannte Heatpipes als Wärmesenke geeignet.

Ferner ist bei der erfindungsgemäßen Beleuchtungseinrichtung vorzugsweise vorgesehen, dass Zwischenräume zwischen den Submounts mit Kunststoff aufgefüllt sind.

Um eine nicht als Leuchtdiode erhältliche Farbe zu erzielen oder ein farbiges Display zu hinterleuchten, ist vorgesehen, dass die Leuchtdioden jeweils eines Leuchtpunktes verschieden farbiges Licht aussenden.

Die Verwendung mehrerer Leuchtdioden für jeweils einen Leuchtpunkt hat den Vorteil einer höheren Lichtausbeute gegenüber einer größeren Leuchtdiode. Es hat sich als günstig herausgestellt, wenn vier Leuchtdioden einen Leuchtpunkt bilden. Im Rahmen der Erfindung ist jedoch auch eine andere Zahl von Leuchtdioden pro Leuchtpunkt möglich.

Eine andere vorteilhafte Ausgestaltung besteht darin, dass zwei grün leuchtende Leuchtdioden, eine blau leuchtende und eine rot leuchtende Leuchtdiode je Leuchtpunkt vorgesehen sind. Damit wird zwar die grüne Komponente des erzeugten Lichts gegenüber den anderen hervorgehoben, was notwendig ist, um weiß zu erhalten, beispielsweise circa 60 % grün, 25 % rot und 15 % blau.

Die Anordnung der Leuchtpunkte auf Submounts hat den Vorteil, dass die Seitenwände der Leuchtdioden sich vollständig über die zwischen den Leuchtpunkten geführten Leitungen erheben, so dass die hiervon ausgehende Strahlung genutzt werden kann. Um diese zur Hinterleuchtung des Displays zu nutzen, ist bei einer anderen Weiterbildung der Erfindung vorgesehen, dass die Leuchtpunkte von jeweils einem Reflektor umgeben sind. Vorzugsweise ist dabei vorgesehen, dass eine vom Reflektor gebildete den Leuchtpunkt enthaltende Vertiefung mit einem transparenten Kunststoff aufgefüllt ist.

Die erfindungsgemäße Lichtquelle weist eine hohe Effizienz, hohe Lebensdauer, große Ausfallsicherheit, definierte Abstrahlung und - bei Verwendung verschiedenfarbiger Leuchtdioden - eine engbandige Abstrahlung in verschiedenen Farben auf. Damit ist es möglich, die spektrale Emission der Lichtquelle und spektrale Transmission der Farbfilter des Flüssigkristall-Displays in Übereinstimmung zu bringen und die Lichtverluste durch die Farbfilter gering zu halten. Durch die hohe Effizienz der Leuchtdioden wird eine große Intensität bei geringer Wärmeerzeugung erreicht.

Die gleichmäßige Verteilung der Farbpunkte über die gesamte Sichtfläche führt in Verbindung mit einer geeigneten Bündelungseinrichtung zu einer weiteren effektiven Erhöhung der Leuchtdichte. Dabei führt die gleichmäßige Verteilung der Leuchtpunkte über die gesamte Sichtfläche zu einer gleichmäßigen Leuchtdichteverteilung, die durch die Bündelungseinrichtung weiter erhöht werden kann. Die kompakte Anordnung der Leuchtdioden in jeweils einem Leuchtpunkt führt zu einer guten Farbmischung. Durch die weiß reflektierende Fläche und die Reflektorform wird Licht, das nun unter ungünstigerem Winkel emittiert wird, genutzt. Die Verwendung von sehr kleinen Leuchtdioden führt zu einer kompakten Anordnung mit einer Dicke von wenigen Millimetern, beispielsweise 2 mm.

Die Leuchtdioden benötigen eine sehr niedrige Betriebsspannung, so dass zweckmäßigerweise mehrere Leuchtdioden in Reihe geschaltet werden. Bei Ausfall einer dieser Leuchtdioden werden die anderen nicht mehr mit Strom versorgt und fallen ebenfalls aus. Um eine Sichtbarkeit dieses Effekts zu verringern oder gegebenenfalls sogar auszuschließen, ist vorgesehen, dass jeweils eine Leuchtdiode eines Leuchtpunktes mit jeweils einer Leuchtdiode mehrerer anderer Leuchtpunkte in Reihe geschaltet einen Stromkreis bilden.

Um dabei zu verhindern, dass bei Ausfall einer Leuchtdiode besonders störende Streifen oder Flecken entstehen, kann die Beleuchtungseinrichtung in einer Weiterbildung derart ausgebildet sein, dass die Leuchtpunkte, deren Leuchtdioden jeweils zu einem Stromkreis gehören, mit Leuchtpunkten mindestens eines anderen Stromkreises verschachtelt angeordnet sind. Durch die Verschachtelung ist es mit geeigneten optischen Lichtverteilungsmitteln möglich, den Ausfall einer Gruppe kaum sichtbar zu machen.

Es sind mehrere gleichfarbige Leuchtdioden je Leuchtpunkt vorhanden, wobei die gleichfarbigen Leuchtdioden an verschiedene Stromkreise angeschlossen sind. Ohne weitere Maßnahmen tritt dabei eine Helligkeits- und Farbänderung auf, die für viele Anwendungen toleriert werden kann.

Ein Ausgleich der Farbänderung erfolgt dadurch, dass Steuereinrichtungen für die den einzelnen Stromkreisen zugeführten Ströme vorgesehen sind, die bei Unterbrechung eines der Stromkreise für gleichfarbige Leuchtdioden die Ströme in den Stromkreisen für den mindestens einen anderen Stromkreis für gleichfarbige Leuchtdioden und für andersfarbige Leuchtdioden der gleichen Leuchtpunkte im Sinne eines Ausgleichs der durch die Unterbrechung bedingten Farbverschiebung steuern.

Sofern es in Hinblick auf die zulässige Verlustleistung der betroffenen Leuchtdioden möglich ist, kann dabei vorgesehen sein, dass der Strom in dem mindestens einen anderen Stromkreis für gleichfarbige Leuchtdioden heraufgesetzt wird. Mit dieser Maßnahme können sowohl die Helligkeit als auch die Farbe auf den Originalzustand gebracht werden.

Sollte eine Leistungserhöhung der verbleibenden gleichfarbigen Leuchtdioden nicht möglich oder zweckmäßig sein, so können die Ströme in den Stromkreisen für andersfarbige Leuchtdioden herabgesetzt werden. Dadurch verringert sich zwar die Helligkeit, die Farbe kann jedoch im Wesentlichen erhalten bleiben.

Eine andere vorteilhafte Ausgestaltung der Weiterbildung besteht darin, dass ein Raster von 4 x 8 Leuchtpunkten mit jeweils zwei grünleuchtenden und zwei rotleuchtenden Leuchtdioden vorhanden ist, dass für die rotleuchtenden Leuchtdioden vier Stromkreise vorgesehen sind, wobei jeweils zwei Stromkreise den Leuchtdioden gleicher Leuchtpunkte zugeordnet sind, die schachbrettförmig über das Raster verteilt sind. Hierbei ist vorzugsweise vorgesehen, dass die grünleuchtenden Leuchtdioden an acht Stromkreise angeschlossen sind, wobei jeweils eine grünleuchtende Leuchtdiode von acht Leuchtpunkten an einen und eine weitere grünleuchtende Leuchtdiode von den gleichen Leuchtpunkten an einen anderen Stromkreis angeschlossen ist.

Bei dieser Ausgestaltung wird berücksichtigt, dass wegen der unterschiedlichen benötigten Spannungen der rotleuchtenden und der grünleuchtenden Leuchtdioden und wegen einer zweckmäßigen Betriebsspannung in Höhe von etwa 40 V sechszehn rotleuchtende, jedoch nur acht grünleuchtende Leuchtdioden in Reihe geschaltet werden.

Die Erfindung lässt zahlreiche Ausführungsformen zu. Eine davon ist schematisch in der Zeichnung anhand mehrerer Figuren dargestellt und nachfolgend beschrieben. Es zeigen:
- Fig. 1: eine stark schematisierte Darstellung eines mit der erfindungsgemäßen Beleuchtungseinrichtung hinterleuchteten Displays.
- Fig. 2: eine Draufsicht durch ein Ausführungsbeispiel,
- Fig. 3: eine vergrößerte Darstellung eines der Leuchtpunkte,
- Fig. 4: eine Schnittdarstellung eines Leuchtpunktes und der den Leuchtpunkt umgebenden Teile des Ausführungsbeispiels und
- Fig. 5: eine schematische Darstellung der Stromversorgung der Leuchtdioden.

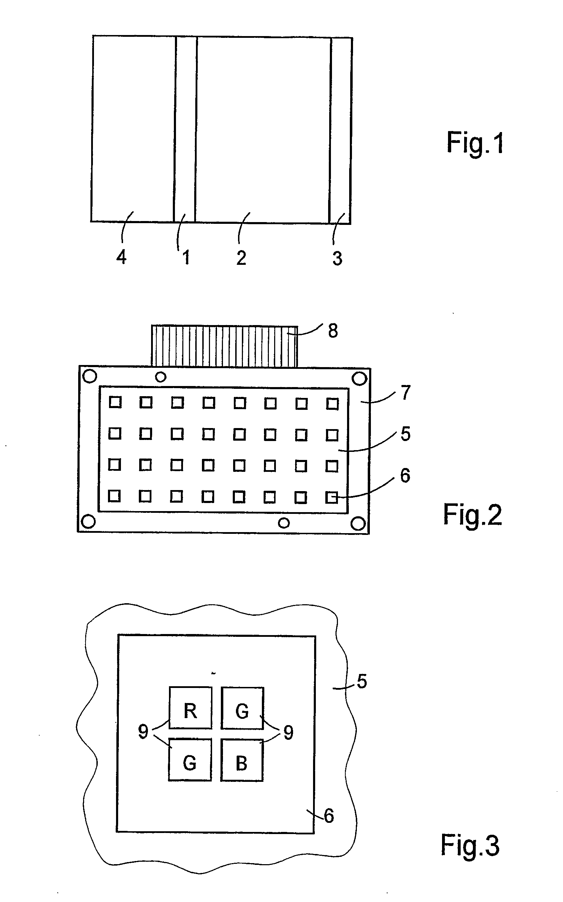

Fig. 1 stellt schematisch eine Anordnung mit einer Lichtquelle 1 und einem Display 3 dar, wobei zwischen der Lichtquelle 1 und dem Display 3 eine optische Einrichtung zur Bündelung des von der Lichtquelle 1 ausgehenden Lichts im Sinne einer gleichmäßigen Verteilung auf die Fläche des Displays 3 vorgesehen ist. Der Abstand zwischen Lichtquelle und Display beträgt einige Zentimeter. Auf der Rückseite der Lichtquelle 1 befindet sich ein Kühlkörper 4 zur Wärmeableitung.

Fig. 2 zeigt eine Draufsicht auf die Lichtquelle 1 mit einem weißen Kunststoffrahmen, der bei dem dargestellten Ausführungsbeispiel 8 x 4 Löcher enthält, in denen sich Leuchtpunkte 6 befinden. Die Größe des Kunststoffrahmens 5 entspricht der sichtbaren Fläche des Displays. Der Kunststoffrahmen 5 und die Leuchtpunkte 6 befinden sich auf einer Aluminiumplatte 7, die zur Befestigung und Wärmeabführung dient. Seitlich sind Leitungen in Form eines Flachbandkabels 8 zur Verbindung der Leuchtdioden mit einer Stromquelle herausgeführt.

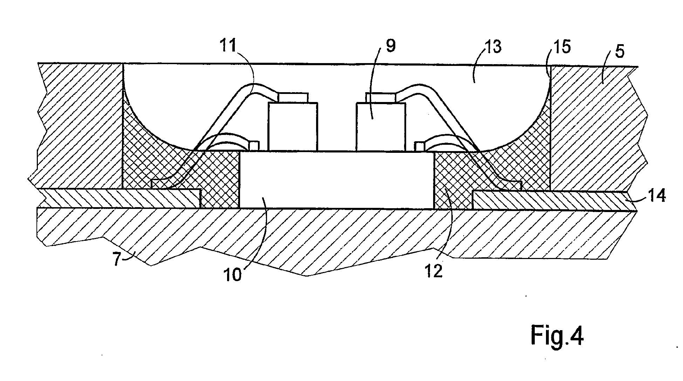

Fig. 3 zeigt eine vergrößerte Darstellung eines Leuchtpunktes 6, der von einem Loch in dem Kunststoffrahmen 5 gebildet ist. Vier Leuchtdioden 9 sind erhöht in der Mitte des Loches auf einem Submount 10 (Fig. 4) angeordnet. Die Leuchtdioden sind über Bonddrähte 11 mit Leitungen 14 verbunden, die lediglich schematisch durch Schraffur der von ihnen eingenommenen Fläche dargestellt sind. In einer bevorzugten Ausführungsform ist eine der Leuchtdioden rot leuchtend, zwei sind grün leuchtend und die vierte leuchtet blau. Bei dieser Anordnung mischt sich das Licht zu weiß. Der Raum zwischen dem Submount 10 und dem Rahmen 5 ist mit einer weißen Vergussmasse 12 aufgefüllt, deren Oberfläche 15 als Reflektor für das seitlich von den Leuchtdioden 9 ausgestrahlte Licht dient. Eine transparente Vergussmasse 13 sorgt für eine glatte Oberfläche der Lichtquelle und den Schutz der Bonddrähte und Leuchtdioden.

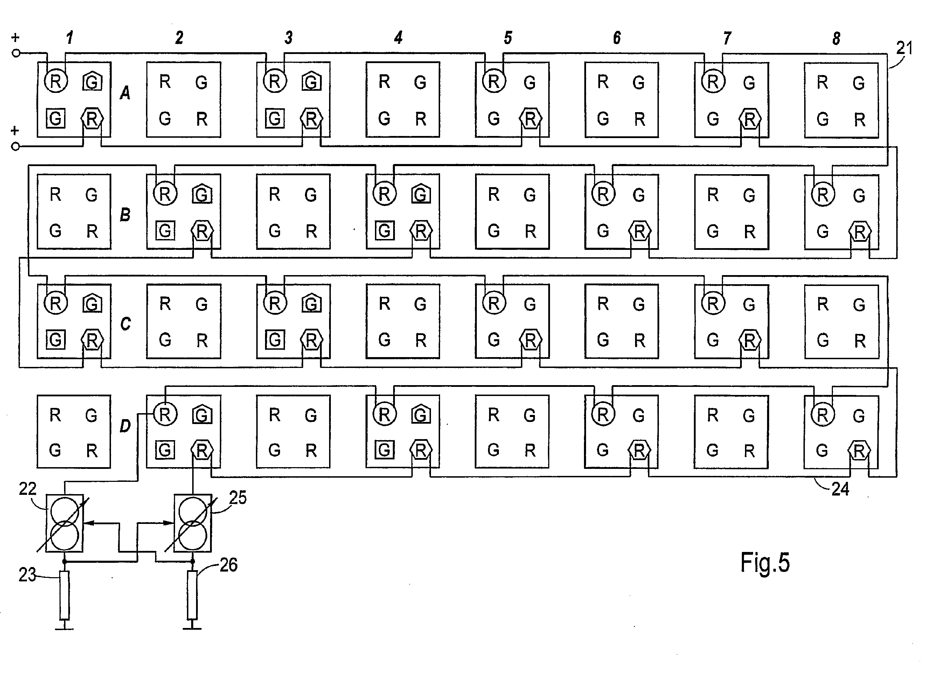

Fig. 5 stellt schematisch den Anschluss der Leuchtdioden eines Ausführungsbeispiels mit 32 Leuchtpunkten an Stromkreise dar. Da die Vielzahl der Verbindungen nur unzureichend und unübersichtlich in einer Zeichnung dargestellt werden kann, sind die Leuchtdioden, deren Stromversorgung im Einzelnen dargestellt oder beschrieben ist, mit verschiedenen Symbolen entsprechend ihrer Zugehörigkeit zu einzelnen Stromkreisen gekennzeichnet. Es sind zwei Stromkreise für rotleuchtende Leuchtdioden - im folgenden auch rote Leuchtdioden genannt - im Detail dargestellt. Die Spalten des Rasters sind mit 1 bis 8 nummeriert, während die Zeilen mit den Buchstaben A bis D gekennzeichnet sind. Zum Unterschied zu den anderweitig verwandten Bezugszeichen sind die Spaltennummern in Fig. 5 kursiv gedruckt.

Jeweils eine der roten Leuchtdioden R der Leuchtpunkte A1, A3, A5, A7, B2, B4 bis D8 ist an einen Stromkreis 21 angeschlossen, der ferner eine steuerbare Stromquelle 22 und einen Strom-Messwiderstand 23 enthält. In gleicher Weise sind die jeweils anderen roten Leuchtdioden der gleichen Leuchtpunkte, nämlich A1, A3 bis D8 an einen weiteren Stromkreis 24 mit einer steuerbaren Stromquelle 25 und einem Strom-Messwiderstand 26 angeschlossen. Entsprechend sind die grünen Leuchtdioden der Leuchtpunkte A1, A3, B2, B4, C1 C3, D2 und D4 an zwei weitere nicht dargestellte Stromkreise angeschlossen. Zwei weitere nicht dargestellte Stromkreise versorgen die grünen Leuchtdioden der Leuchtpunkte A5, A7, B6, B8, C5, C7, D6 und D8. Die Stromversorgung der Leuchtpunkte A2, A4, A6, A8 bis D7 erfolgt entsprechend.

Im normalen Betriebszustand werden somit alle Leuchtdioden mit derart vorgegebenen Strömen versorgt, dass das resultierende Licht die gewünschte Farbe aufweist. Fällt nun beispielsweise eine der an den Stromkreis 21 angeschlossenen roten Leuchtdioden aus, wird dieses mit Hilfe des ausbleibenden Spannungsabfalls am Strom-Messwiderstand 23 festgestellt und die Stromquelle 25 im Sinne einer Erhöhung des Stroms im Stromkreis 24 gesteuert. Sollte dieses aus Gründen der Belastbarkeit der betroffenen Leuchtdioden oder der Wärmebilanz der einzelnen Leuchtpunkte nicht möglich sein, so kann - was in Fig. 5 nicht dargestellt ist - eine Herabsetzung der Ströme in den grünen Leuchtdioden vorgenommen werden.

Durch die Verschachtelung der Leuchtpunkte werden Strukturen, die bei Änderung der Farbe und/oder Helligkeit von an gleichen Stromkreisen angeschlossenen Leuchtpunkten entstehen, weniger sichtbar und können durch optische Mittel besser verteilt werden als beispielsweise bei einer zeilen- oder spaltenförmigen Zuordnung der Leuchtpunkte zu den jeweiligen Stromkreisen.

## Patentansprüche

1. Beleuchtungseinrichtung zur Hinterleuchtung einer Lichtventile enthaltenden Bildwiedergabevorrichtung, beinhaltend einen flachen wärmeleitenden Träger (7) und jeweils von mehreren Leuchtdioden (9) gebildete Leuchtpunkte (6), die rasterförmig angeordnet sind, wobei die Leuchtdioden jeweils eines Leuchtpunktes verschieden farbiges Licht aussenden und wobei jeweils eine Leuchtdiode eines Leuchtpunktes mit jeweils einer Leuchtdiode mehrerer anderer Leuchtpunkte in Reihe geschaltet einen Stromkreis bilden,
**dadurch gekennzeichnet,**
**dass** die Leuchtdioden jeweils eines Leuchtpunktes (6) auf der im Wesentlichen ebenen Oberfläche eines Submounts (10) elektrisch isoliert aufgebracht sind,
**dass** die Submounts (10) gut wärmeleitend sind und gut wärmeleitend mit dem flachen wärmeleitenden Träger (7) verbunden sind,
**dass** mehrere gleichfarbige Leuchtdioden je Leuchtpunkt vorhanden sind, wobei die gleichfarbigen Leuchtdioden an verschiedene Stromkreise angeschlossen sind und
**dass** Steuereinrichtungen für die den einzelnen Stromkreisen zugeführten Ströme vorgesehen sind, die bei Unterbrechung eines der Stromkreise für gleichfarbige Leuchtdioden die Ströme in dem mindestens einen anderen Stromkreis für gleichfarbige Leuchtdioden und in den Stromkreisen für andersfarbige Leuchtdioden der gleichen Leuchtpunkte im Sinne eines Ausgleichs der durch die Unterbrechung bedingten Farbverschiebung steuern.

2. Beleuchtungseinrichtung nach Anspruch 1, **dadurch gekennzeichnet, dass** die Fläche der Submounts (10) jeweils kleiner als die durch das Raster gegebene Fläche ist und dass auf der nicht von Submounts (10) eingenommenen Fläche des Trägers (7) zwischen den Submounts (10) auf einem isolierenden Träger Leitungen (14) zur Stromversorgung der Leuchtdioden (9) angeordnet sind.

3. Beleuchtungseinrichtung nach Anspruch 2, **dadurch gekennzeichnet, dass** die Leitungen (14) in einer flexiblen Folie geführt sind, die außerhalb des Trägers als Flachleitung (8) fortgesetzt ist.

4. Beleuchtungseinrichtung nach einem der vorhergehenden Ansprüche, **dadurch gekennzeichnet, dass** die Submounts (10) aus Silizium bestehen.

5. Beleuchtungseinrichtung nach einem der vorhergehenden Ansprüche, **dadurch gekennzeichnet, dass** der Träger (7) aus Reinst-Aluminium besteht.

6. Beleuchtungseinrichtung nach einem der Ansprüche 1 bis 4, **dadurch gekennzeichnet, dass** der Träger (7) aus Kupfer besteht.

7. Beleuchtungseinrichtung nach einem der vorhergehenden Ansprüche, **dadurch gekennzeichnet, dass** der Träger (7) mit einer Wärmesenke verbunden ist.

8. Beleuchtungseinrichtung nach Anspruch 2, **dadurch gekennzeichnet, dass** Zwischenräume zwischen den Submounts (10) mit Kunststoff (5, 12) aufgefüllt sind.

9. Beleuchtungseinrichtung nach einem der vorhergehenden Ansprüche, **dadurch gekennzeichnet, dass** vier Leuchtdioden (9) einen Leuchtpunkt (6) bilden.

10. Beleuchtungseinrichtung nach Anspruch 9, **dadurch gekennzeichnet, dass** zwei grün leuchtende Leuchtdioden, eine blau leuchtende und eine rot leuchtende Leuchtdiode je Leuchtpunkt (6) vorgesehen sind.

11. Beleuchtungseinrichtung nach einem der vorhergehenden Ansprüche, **dadurch gekennzeichnet, dass** die Leuchtpunkte (6) von jeweils einem Reflektor (15) umgeben sind.

12. Beleuchtungseinrichtung nach Anspruch 11, **dadurch gekennzeichnet, dass** eine vom Reflektor (15) gebildete den Leuchtpunkt enthaltende Vertiefung mit einem transparenten Kunststoff (13) aufgefüllt ist.

13. Beleuchtungseinrichtung nach einem der vorhergehenden Ansprüche, **dadurch gekennzeichnet, dass** die Leuchtpunkte, deren Leuchtdioden jeweils zu einem Stromkreis gehören, mit Leuchtpunkten mindestens eines anderen Stromkreises verschachtelt angeordnet sind.

14. Beleuchtungseinrichtung nach einem der vorhergehenden Ansprüche, **dadurch gekennzeichnet, dass** die Steuereinrichtungen so beschaffen sind, dass der Strom in dem mindestens einen anderen Stromkreis für gleichfarbige Leuchtdioden heraufgesetzt wird.

15. Beleuchtungseinrichtung nach einem der vorhergehenden Ansprüche, **dadurch gekennzeichnet, dass** die Steuereinrichtungen so beschaffen sind, dass die Ströme in den Stromkreisen für andersfarbige Leuchtdioden herabgesetzt werden.

16. Beleuchtungseinrichtung nach einem der vorhergehenden Ansprüche, **dadurch gekennzeichnet, dass** ein Raster von 4 x 8 Leuchtpunkten mit jeweils zwei grünleuchtenden und zwei rotleuchtenden Leuchtdioden vorhanden ist, dass für die rotleuchtenden Leuchtdioden vier Stromkreise vorgesehen sind, wobei jeweils zwei Stromkreise den Leuchtdioden gleicher Leuchtpunkte zugeordnet sind, die schachbrettförmig über das Raster verteilt sind.

17. Beleuchtungseinrichtung nach Anspruch 16, **dadurch gekennzeichnet, dass** die grünleuchtenden Leuchtdioden an acht Stromkreise angeschlossen sind, wobei jeweils eine grünleuchtende Leuchtdiode von acht Leuchtpunkten an einen und eine weitere grünleuchtende Leuchtdiode von den gleichen Leuchtpunkten an einen anderen Stromkreis angeschlossen ist.

## Claims

1. Illumination device for backlighting an image reproduction device containing light valves, comprising a flat thermally conductive carrier (7) and luminous spots (6) formed by a plurality of light-emitting diodes (9) in each case, said luminous spots being arranged in grid form, wherein the light-emitting diodes of a respective luminous spot emit differently coloured light and wherein a respective light-emitting diode of one luminous spot with a respective light-emitting diode of a plurality of other luminous spots, connected in series, form an electric circuit, **characterized**
**in that** the light-emitting diodes of a respective luminous spot (6) are applied in an electrically insulating manner on the substantially planar surface of a submount (10),
**in that** the submounts (10) have good thermal conductivity and are connected to the flat thermally conductive carrier (7) in a manner exhibiting good thermal conductivity,
**in that** a plurality of identically coloured light-emitting diodes are present per luminous spot, wherein the identically coloured light-emitting diodes are connected to different electric circuits, and
**in that** control devices are provided for the currents fed to the individual electric circuits, which control devices, in the event of interruption of one of the electric circuits for identically coloured light-emitting diodes, control the currents in the at least one other electric circuit for identically coloured light-emitting diodes and in the electric circuits for differently coloured light-emitting diodes of the same luminous spots in the sense of compensating for the colour shift brought about by the interruption.

2. Illumination device according to Claim 1, **characterized in that** the area of the submounts (10) is in each case less than the area provided by the grid, and **in that** lines (14) for supplying power to the light-emitting diodes (9) are arranged between the submounts (10) on an insulating carrier on that area of the carrier (7) which is not occupied by submounts (10).

3. Illumination device according to Claim 2, **characterized in that** the lines (14) are routed in a flexible film that is continued as a flat lead (8) outside the carrier.

4. Illumination device according to any of the preceding claims, **characterized in that** the submounts (10) consist of silicon.

5. Illumination device according to any of the preceding claims, **characterized in that** the carrier (7) consists of ultrapure aluminium.

6. Illumination device according to any of Claims 1 to 4, **characterized in that** the carrier (7) consists of copper.

7. Illumination device according to any of the preceding claims, **characterized in that** the carrier (7) is connected to a heat sink.

8. Illumination device according to Claim 2, **characterized in that** interspaces between the submounts (10) are filled with plastic (5, 12).

9. Illumination device according to any of the preceding claims, **characterized in that** four light-emitting diodes (9) form a luminous spot (6).

10. Illumination device according to Claim 9, **characterized in that** two green-luminous light-emitting diodes, one blue-luminous and one red-luminous light-emitting diode are provided per luminous spot (6).

11. Illumination device according to any of the preceding claims, **characterized in that** the luminous spots (6) are surrounded by a respective reflector (15).

12. Illumination device according to Claim 11, **characterized in that** a depression that is formed by the reflector (15) and contains the luminous spot is filled with a transparent plastic (13).

13. Illumination device according to any of the preceding claims, **characterized in that** the luminous spots whose light-emitting diodes are in each case associated with one electric circuit are arranged in a manner interleaved with luminous spots of at least one other electric circuit.

14. Illumination device according to any of the preceding claims, **characterized in that** the control devices are constituted such that the current in the at least one other electric circuit for identically coloured light-emitting diodes is increased.

15. Illumination device according to any of the preceding claims, **characterized in that** the control devices are constituted such that the currents in the electric circuits for differently coloured light-emitting diodes are decreased.

16. Illumination device according to any of the preceding claims, **characterized in that** a grid of 4 x 8 luminous spots having in each case two green-luminous and two red-luminous light-emitting diodes is present, **in that** four electric circuits are provided for the red-luminous light-emitting diodes, wherein two electric circuits in each case are assigned to the light-emitting diodes of identical luminous spots which are distributed over the grid in a chequered fashion.

17. Illumination device according to Claim 16, **characterized in that** the green-luminous light-emitting diodes are connected to eight electric circuits, wherein in each case one green-luminous light-emitting diode of eight luminous spots is connected to one electric circuit and a further green-luminous light-emitting diode of the same luminous spots is connected to another electric circuit.

## Revendications

1. Dispositif d'éclairage pour le rétroéclairage d'un dispositif de reproduction d'image contenant des valves optiques, contenant un support (7) thermoconducteur plat et des points lumineux (6) respectivement formés par plusieurs diodes électroluminescentes (9), lesquels sont disposés en forme de grille, les diodes électroluminescentes émettant respectivement un point lumineux ayant une lumière colorée différente et une diode électroluminescente d'un point lumineux étant à chaque fois branchée en série avec respectivement une diode électroluminescente de plusieurs autres points lumineux et formant un circuit électrique,
**caractérisé en ce**
**que** les diodes électroluminescentes d'un point lumineux (6) respectif sont montées de manière électriquement isolée sur la surface sensiblement plane d'un sous-support (10),
**que** les sous-supports (10) présentent une bonne conductivité thermique et sont reliés avec une bonne conductivité thermique avec le support (7) thermoconducteur plat,
**que** plusieurs diodes électroluminescentes de même couleur sont présentes à chaque point lumineux, les diodes électroluminescentes de même couleur étant raccordées à des circuits électriques différents et
**que** des dispositifs de commande sont prévus pour les courants acheminés aux circuits électriques individuels, lesquels, en cas d'interruption de l'un des circuits électriques pour des diodes électroluminescentes de même couleur, commandent les courants dans l'au moins un autre circuit électrique pour des diodes électroluminescentes de même couleur et dans les circuits électriques pour des diodes électroluminescentes de couleurs différentes des mêmes points lumineux dans le sens d'une compensation du décalage de couleur provoqué par l'interruption.

2. Dispositif d'éclairage selon la revendication 1, **caractérisé en ce que** la surface des sous-supports (10) est à chaque fois plus petite que la surface définie par la grille et **en ce que** des lignes (14) destinées à l'alimentation électrique des diodes électroluminescentes (9) sont disposées entre les sous-supports (10) sur un support isolant sur la surface du support (7) non occupée par les sous-supports (10).

3. Dispositif d'éclairage selon la revendication 2, **caractérisé en ce que** les lignes (14) sont guidées dans un film flexible qui se poursuit en dehors du support sous la forme d'un câble plat (8).

4. Dispositif d'éclairage selon l'une des revendications précédentes, **caractérisé en ce que** les sous-supports (10) sont constitués de silicium.

5. Dispositif d'éclairage selon l'une des revendications précédentes, **caractérisé en ce que** le support (7) est constitué d'aluminium pur.

6. Dispositif d'éclairage selon l'une des revendications 1 à 4, **caractérisé en ce que** le support (7) est constitué de cuivre.

7. Dispositif d'éclairage selon l'une des revendications précédentes, **caractérisé en ce que** le support (7) est relié avec un dissipateur thermique.

8. Dispositif d'éclairage selon la revendication 2, **caractérisé en ce que** les espaces intermédiaires entre les sous-supports (10) sont remplis de matière plastique (5, 12).

9. Dispositif d'éclairage selon l'une des revendications précédentes, **caractérisé en ce que** quatre diodes électroluminescentes (9) forment un point lumineux (6).

10. Dispositif d'éclairage selon la revendication 9, **caractérisé en ce que** deux diodes électroluminescentes s'allumant en vert, une diode électroluminescente s'allumant en bleu et une diode électroluminescente s'allumant en rouge sont prévues pour chaque point lumineux (6).

11. Dispositif d'éclairage selon l'une des revendications précédentes, **caractérisé en ce que** les points lumineux (6) sont respectivement entourés par un réflecteur (15).

12. Dispositif d'éclairage selon la revendication 11, **caractérisé en ce qu'**un enfoncement formé par le réflecteur (15) et contenant le point lumineux est rempli d'une matière plastique transparente (13).

13. Dispositif d'éclairage selon l'une des revendications précédentes, **caractérisé en ce que** les points lumineux dont les diodes électroluminescentes font respectivement partie d'un circuit électrique sont disposés de manière imbriquée avec les points lumineux d'au moins un autre circuit électrique.

14. Dispositif d'éclairage selon l'une des revendications précédentes, **caractérisé en ce que** les dispositifs de commande sont conçus de telle sorte que le courant dans l'au moins un autre circuit électrique est relevé pour les diodes électroluminescente de même couleur.

15. Dispositif d'éclairage selon l'une des revendications précédentes, **caractérisé en ce que** les dispositifs de commande sont conçus de telle sorte que les courants dans les circuits électriques sont abaissés pour les diodes électroluminescentes d'une autre couleur.

16. Dispositif d'éclairage selon l'une des revendications précédentes, **caractérisé en ce qu'**il existe une grille de 4 x 8 points lumineux comprenant à chaque fois deux diodes électroluminescentes s'allumant en vert et deux s'allumant en rouge, **en ce que** quatre circuits électriques sont prévus pour les diodes électroluminescentes s'allumant en rouge, deux circuits électriques étant respectivement associés aux diodes électroluminescentes des mêmes points lumineux, lesquels sont répartis en échiquier sur la grille.

17. Dispositif d'éclairage selon la revendication 16, **caractérisé en ce que** les diodes électroluminescentes s'allumant en vert sont raccordées à huit circuits électriques, une diode électroluminescente s'allumant en vert de huit points lumineux étant à chaque fois raccordée à un circuit électrique et une autre diode électroluminescente s'allumant en vert des mêmes points lumineux étant à chaque fois raccordée à un autre circuit électrique.
